# EUROPEAN PATENT APPLICATION

(11) **EP 1 976 132 A2**
(43) Date of publication of application: **01.10.2008**
(21) Application number: 08251247.6
(22) Date of filing: 31.03.2008
(51) Int. Cl.: H04B 1/30, H03F 3/217, H03D 7/18

(54) **System and method for digital modulation**

(30) Priority: 30.03.2007 US 694495
(71) Applicant: Optimal Innovations Inc, Bridgetown (BB)
(72) Inventor: Chow, Peter El Kwan, Orlando, Florida 32836 (US)
(74) Representative: Jackson, Richard Eric

(57) **Abstract**

The present invention is directed to a system and method which allows for power amplification of an input signal using power amplification combined by changing the center frequency with an up-converter to shift a baseband signal to a signal at a carrier frequency in the same process. This then provides a digital implementation that is power efficient and has little or no linearity issue - technology suitable for a silicon chip and broadband operation. In one embodiment, each input sample is replaced with a number of sub-samples within the same sample interval, the total weight of the sub-samples being equal to the replaced sample. This sample to sub-samples process alters the frequency response of the sampled signal and reduces the amplitude dynamic range of the load driver, thereby simplifying the filter requirements for digital to analog conversion while reducing linearity requirement of the load driver. This process can be implemented by digital circuits which results in broadband operation.

## Description

### TECHNICAL FIELD

This disclosure relates generally to digital modulation techniques and more particularly to systems and methods for power amplification and transmission.

### BACKGROUND OF THE INVENTION

The basic function of the digital modulation is the signal power amplification, i.e. power amplifiers. Power amplifier gain is equal to the ratio of output power to input power. There are many types of power amplifiers, and the reason for so many types is the trade-off of the performance parameters, like implementation simplicity, distortion (nonlinear characteristic), power efficiency and filter requirements. The ideal choice is to have a two level load driver at the power amplifier output stage which provides power efficiency, no distortion, simple filter requirements and simple implementation if it can be integrated into a silicon chip. Class D amplifiers meet the ideal solution, except that they can be operated only in low frequency, like high power audio amplifier up to 20kHz bandwidth. The class D amplifier is built with an analog circuitry, so it has high distortion.

Up-converting from baseband to particular carrier frequencies is a well-known function in a RF transmitter. Traditionally, this is accomplished by a non-linear process in which the baseband signal is multiplied by a carrier frequency signal. Such conversions use a mixer and oscillator which have nonlinear characteristics. The nonlinear characteristic process adds harmonics and other spurious noise. It is possible for the harmonics to be filtered out, but the in-band noise would remain with the signal as a gradation from the conversion.

There are two design approaches in up-converting processes: the single stage and the two stage. The problem with the single stage approach is the carrier frequency leaky control, and therefore the single stage approach it is not commonly used. The second is the two stage up-converting process, wherein the processing is first converted to an intermediate frequency (IF), and then the IF is converted to the carrier frequency. This creates more demands on filtering and the choice of IF frequency for minimizing the in-band noise than from the two stages of the non-linear process. When the non-linearity of the power amplifier is included, the transmitter process has in-band noise from three non-linear sources.

Another problem with such traditional circuits is that each baseband to carrier frequency conversion (in terms of selected frequencies) requires a unique design in order to avoid the harmonics and other spurious signals that result from the specific addition and subtraction of frequencies required to achieve the desired result. This problem then causes each product design to be unique every time, and thus involves engineering effort for introducing every new product.

### BRIEF SUMMARY OF THE INVENTION

The present invention is directed to a system and method which allows for power amplification of an input signal using power amplification combined by changing the center frequency with an up-converter to shift a baseband signal to a signal at a carrier frequency in the same process. This then provides a digital implementation that is power efficient and has little or no linearity issue - technology suitable for a silicon chip and broadband operation. In one embodiment, each input sample is replaced with a number of sub-samples within the same sample interval, the total weight of the sub-samples being equal to the replaced sample. This sample to sub-samples process alters the frequency response of the sampled signal and reduces the amplitude dynamic range of the load driver, thereby simplifying the filter requirements for digital to analog conversion while reducing linearity requirement of the load driver. This process can be implemented by digital circuits which results in broadband operation.

The foregoing has outlined rather broadly the features and technical advantages of the present invention in order that the detailed description of the invention that follows may be better understood. Additional features and advantages of the invention will be described hereinafter which form the subject of the claims of the invention. It should be appreciated by those skilled in the art that the conception and specific embodiment disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims. The novel features which are believed to be characteristic of the invention, both as to its organization and method of operation, together with further objects and advantages will be better understood from the following description when considered in connection with the accompanying figures. It is to be expressly understood, however, that each of the figures is provided for the purpose of illustration and description only and is not intended as a definition of the limits of the present invention.

### BRIEF DESCRIPTION OF THE DRAWINGS

For a more complete understanding of the present invention, reference is now made to the following descriptions taken in conjunction with the accompanying drawing, in which:

FIGURE 1 illustrates a power amplifier embodiment of a system using the concepts of the invention;

FIGURE 2 illustrates a transmitter embodiment of a system using the concepts of the invention;

FIGURE 3 illustrates a time and frequency relationship of a sampled signal;

FIGURE 4 is an illustration of sample and sub-samples relationship in a sampling interval;

FIGURE 5 A, 5B, 5C show one example of a sample value selection chart and the resulting frequency response for an amplifier; and

FIGURES 6A and 6B show one example of a sample value selection chart and the resulting frequency response for a transmitter.

### DETAILED DESCRIPTION OF THE INVENTION

The power amplification process involves a number of stages. The first stage is to digitize the input signal, if it is not already digitized. The second stage is the sample to sub-sample converter which involves replacing each input sample by a sub-samples waveform within the sample interval. The weight of sub-sample waveform in each sampling interval is equal to the sampled amplitude level of that being replaced. The final stage is the amplification of the pulses which does not require a linear devices. The most efficient pulse amplifier is an ON/OFF switch.

The second embodiment is a single stage carrier frequency up-conversion using digital circuits. The process is very simple if it coupled with the first embodiment. In the words, one can the pulse amplifies to a carrier ON/OFF amplifies.

In another embodiment, the carrier frequency is changed for different application or the same FDM application where the total bandwidth is partition into multiple channel with different carrier frequency. This invention can accommodate this application by changing the carrier frequency oscillator only. There is no redesign of the modulator required. The other requirement is that the ratio of the carrier frequency to sampling frequency must be an integer which can be calculated automatically with a programmable phase locked loop divider.

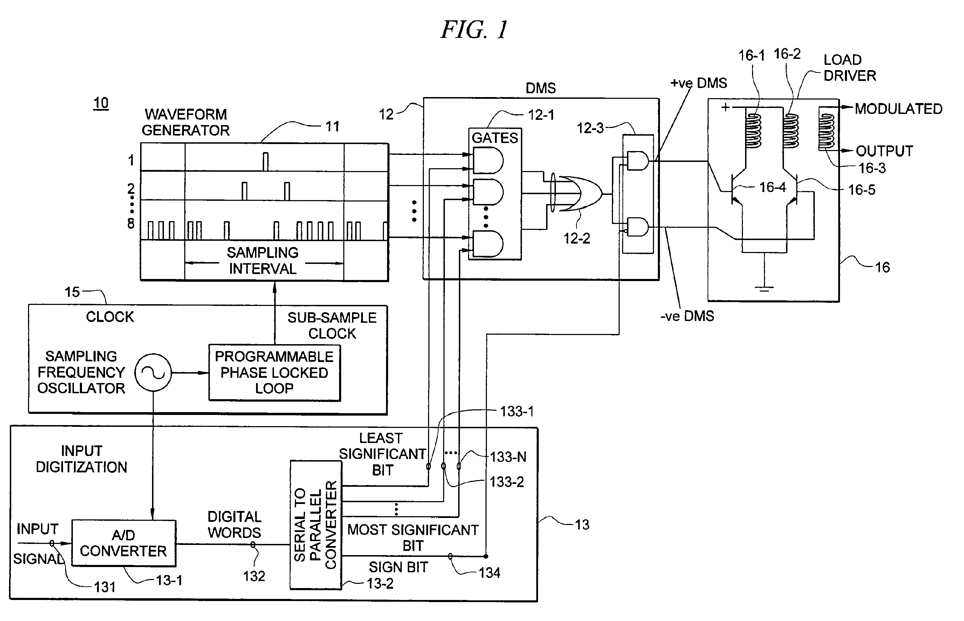

FIGURE 1 illustrates an embodiment 10 of a system using the amplifier concepts of the invention. System 10, in the configuration shown, is a modulator operable using essentially five digital modules for modulating baseband input signal and amplified to drive a load. The five modules are input digitization 13, sub-sampling waveform generators 11, clocks 15, magnitude control of the modulating signal generator 12 and load driver 16.

Input digitization 13 involves the baseband signal which is in analog form and is converted to a digital representation by analog to digital (A/D) converter 13 operating in the well-known fashion. The conversion is a string of digital sample words ofN bits(quantized), each word indicating the input signal amplitude at an instant of sampling time. The word format is n-1 bits of binary coding for magnitude with one bit as the sign bit where N is the total number of bits per sample. The serial to parallel conversion is operated on each digital sample word, i.e., all bits in one word appear as the outputs at the same time and up-dated at each sample interval. The size of N is determined by the noise requirement, sampling frequency and carrier frequency fitering requirment.

The sample to sub-sample conversion function replaces each digital word by a sub-sample time waveform within each sample interval. This process is performed in two stages; the first stage being the sub-sample value waveform generation and the second stage being to create the modulated digital signal.

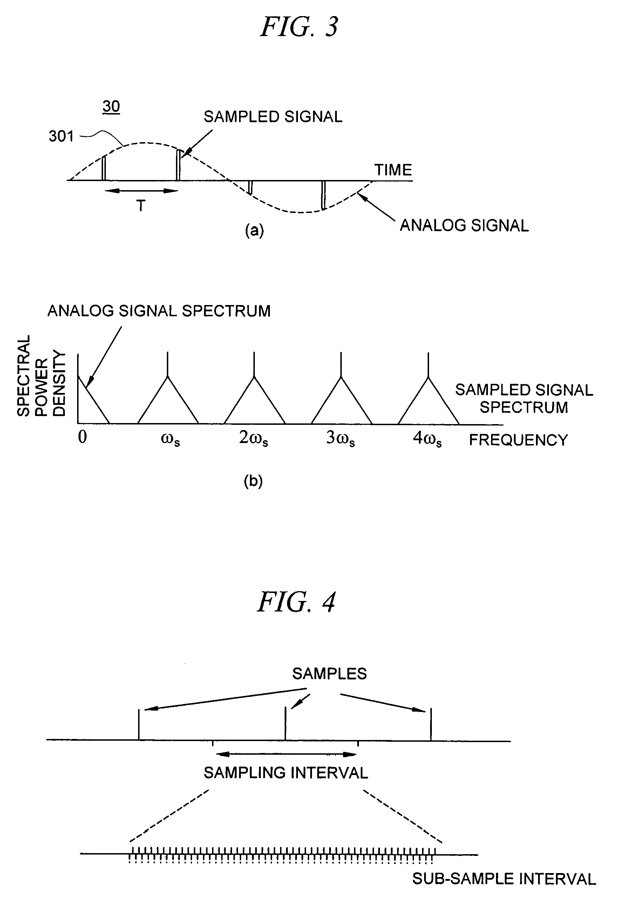

Waveform generators 11 may have outputs from 2 to N-1 based on a number of possible values per sub-samples. If the output is 2, then the sub-sample interval is half of the sample interval. As an example, one output pattern would be "1" in the first sub-sample interval and followed by "0". The other output would be "0" followed by "1". In this context, "1" means a pulse present in the interval and "0" has none. Note that the waveforms are orthogonal to each other. As the number of outputs increase, the patterns have more choices. For simplicity, the following description assumes the number of outputs is N-1, unless otherwise stated. When the number of outputs is N-1, then the pattern value could match each digital bit in the sample word, i.e., the number of "1" in each output could be 1, 2, 3,... or 2^{(N-2)}. The waveform consists of replica unique patterns in each sampling interval. For an example, the least significant bit has a value of 1, so the corresponding sub-sample waveform has a value of one and replica in every sampling interval and so on. The number of sub-sampling intervals in each sampling interval must be greater than or equal to 2^{(N-1)} due to orthogonal among the waveforms' requirement as shown in Fig. 4. Examples provided in this description use the number of sub-sampling intervals per sampling interval as 2^{N} for the same phase shift among waveforms. So the sub-sample waveform of value of 1 has two pulses evenly spaced on both side of the center line of the sample interval.

The choice of unique pattern for each waveform is based on the in-band and out-of-band frequency responses. The in-band frequency response is based on the consistent frequency response for all amplitudes. The out-of-band frequency response is based on the out-of-band signal attenuation.

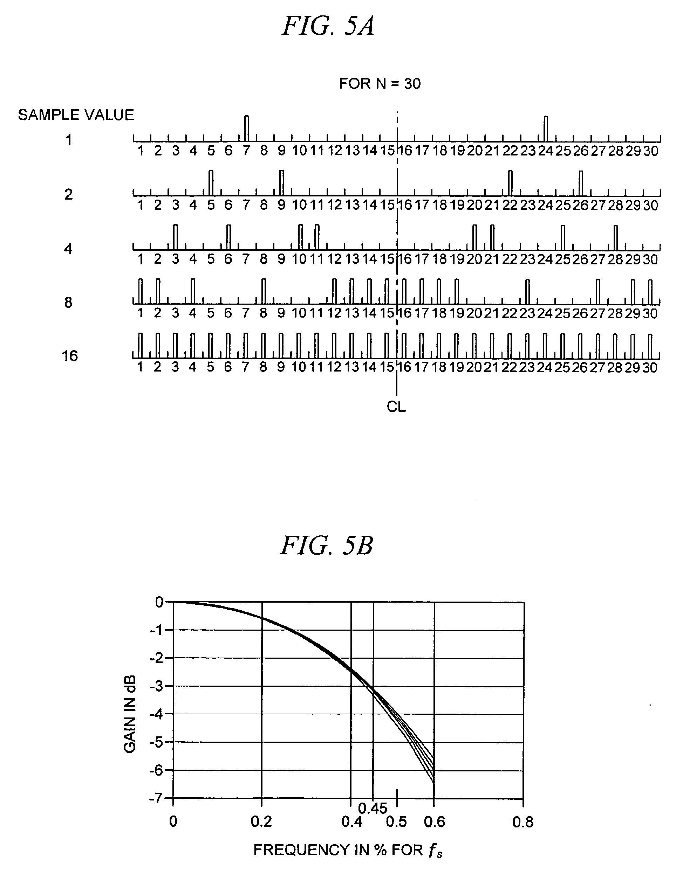

FIGURE 5A is a chart illustrating an example of N = 30 or a digital word of 30 with each sample period having sub-sample intervals. The chart assumes the sub-sample values are either 0.5 or 0 in each sub-sample interval. There are total of 4 sub-sample waveforms with values of 1, 2, 4 and 8 for every sample period. By adding one or more waveforms together with a sign bit, the waveform value could from -15 to 15 in increments of one. This can be done because the waveforms are orthogonal to each other.

FIGURE 5B shows that the normalized frequency response of waveforms shown in FIGURE 5A is almost identitical up to ± 45% of the sampling frequency. The reason is that the selection of waveform patterns is on the criteria for a consistent in-band frequency response for difference sample values. To represent the sample value of 1, the placement of sub-sample values are at both sides of the 9^{th} sub-sample slot from the center line and so on.

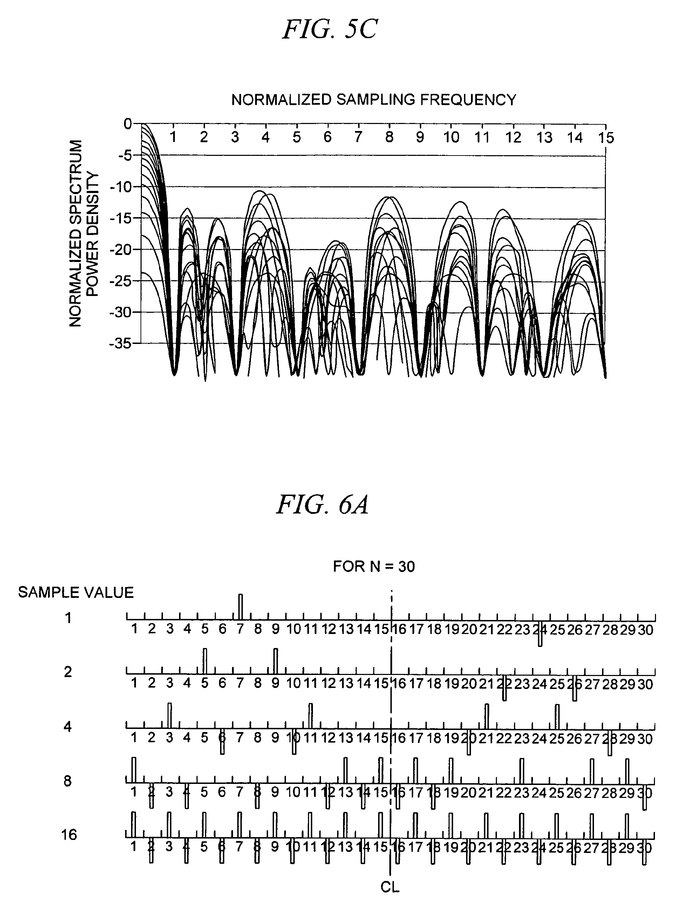

FIGURE 5C shows the normalized frequency response of the sub-sample waveform from 1 to 15 levels over a wide spectrum range. The normalization is based on the peak level, i.e. 15. This is another pattern selection for minimizing the out of band signals. In this example, 15 dB attenuation over the 1^{st} to 3^{rd} sampling frequency range is acehieved which simplifies the filter requirments. This spectrum diagram shows that the digital sample modulated signal has a low pass frequency response at the baseband. The original signal can be repoduced after filtering the out of band signals.

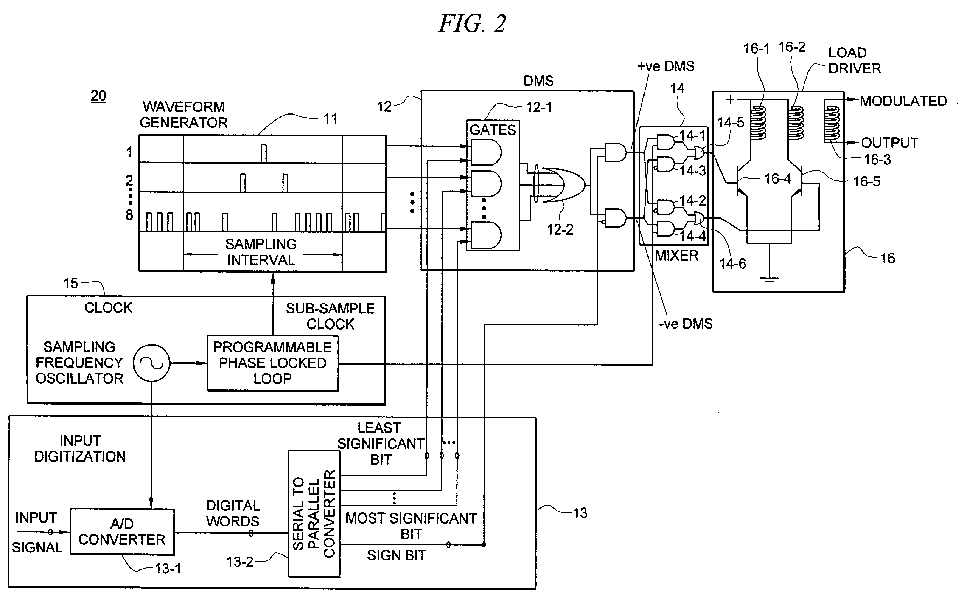

A digital modulated signal is created (as shown in FIGURE 2) by combining the outputs of waveform generators 11 and input digitizer 13. Since outputs of waveform generators 11 are already based on per bit from input digitizer 13, all that is required is to "AND" gate (via gates 12-1) each output from waveform generators 11 and input digitizer 13 with the same value. For an example, the least significant bit should "AND" with the lowest value waveform and so on. The output of the "AND" gate would be either a waveform or zero. In other words, if the least significant bit called for a waveform, then the output is a value 1 waveform. If not, there is no waveform or zero value.The magnitude of the digital modulated signal is the output of "or" gate 12-2 with all inputs from all the "AND" gates. This magnitude waveform is "AND" (via gates 12-3) with a + or - sign bit provided from serial to parallel converter 13-2 to provide positive and negative amplitude of the digital modulated signal.

Load driver 16 is the output stage of the amplifier which delivers the digital modulated signal to the load. It consists of two current paths. Paths 16-4 and 16-1 deliver positive signal to the load, and paths 16-5 and 16-2 deliver negative signal based on the transformer winding direction. Paths 16-4 and 16-5 are on/off switches controlled by the digital modulated signal. If there is a pulse to be transmitted, one switch would be closed and the other would be open. When there is no pulse for transmission, both switches would be open. Once the current is flowing in the transformer, it will transfer the power to secondary winding 16-3 and to the load. Load driver 16 is extremely power-efficient which means the power dissipated in the load driver is a small percentage of the output power. This results from the switched transistors and transformer not dissipating much energy under operation. No power is dissipated when the switch is open, and therefore power dissipation is a percentage of output power. Hence, nonlinearity is not a problem.

Clock circuit 15 has two clocks, i.e., sampling and sub-sampling clocks. The relationship between these two clocks are that the sub-sample clock is an integer multiple of the sampling clock. For broadband operation, this clock circuit preferably would be a separate module from the silicon integrated chip so that the chip can be used for any frequency.

With respect to the number of waveform generator output ports, the above discussion is based on N-4 output ports. One disadvantage is the use of a high sub-sample clock frequency. By reducing the number of output ports, the sub-sample clock frequency would be reduced by half at a time. Referring to FIGURE 5A, let us assume to reduce the output port from 4 to 3. The highest waveform value 8 would be removed. However, since a preferred result would be to have amplitude of the digital modulated signal be the same, e.g., -15 to 15 in increments of one. The following table shows how the 15 levels will be achieved. The table indicates there are two values of pulses, i.e. 0.5 and 1. This can be handled by two load drivers where one output is twice the power of the other.

| Amplitude value | Each pulse value of 0.5 or 0 | Each pulse value of 1 or 0 |
|---|---|---|
| 0 | No waveform | No waveform |
| 1 | SV = 1 | No waveform |
| 2 | No waveform | SV = 1 |
| 3 | SV=1 | SV=1 |
| 4 | No waveform | SV=2 |
| 5 | SV = 1 | SV=2 |
| 6 | No waveform | SV=2 + SV-1 |
| 7 | SV=1 | SV=2+SV-1 |
| 8 | No waveform | SV=8 |
| 9 | SV = 1 | SV=8 |
| 10 | No waveform | SV=8+SV=1 |
| 11 | SV = 1 | SV=8 +SV=1 |
| 12 | No waveform | SV=8+SV=2 |
| 13 | SV = 1 | SV=8+SV=2 |
| 14 | No waveform | SV=8+SV=2+SV=1 |
| 15 | SV = 1 | SV=8+SV=2+SV=1 |

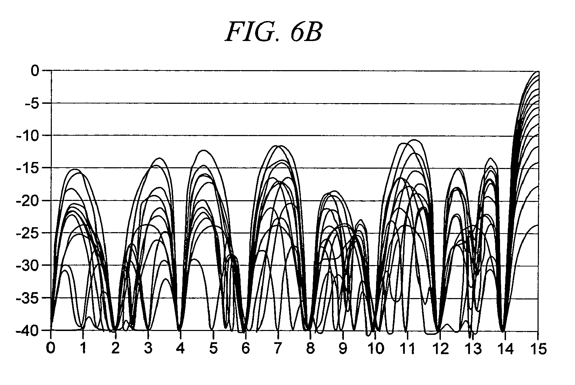

FIGURE 2 shows one embodiment of the concepts discussed herein being used as a transmitter. Clock circuit 15 is set so that the sub-sample clock is twice that of the carrier frequency, each sub-sample clock interval being equal to the half cycle of the carrier waveform. For this reason, the choice of sampling frequency is based on the carrier frequency. This is different from the amplifier implementation where the sample frequency is the prime determining factor. The major difference between the amplifier of FIGURE 1 and the transmitter of FIGURE 6 is that a mixer 14 is added. The mixer 14 transforms the baseband signal to a carrier frequency which is half of the sub-sample clock frequency.

Using the sub-sample waveform shown in FIGURE 5A and making the value in the odd number time slots to be the same and the value in the even number time slots to be negative, the result is shown in FIGURE 6A. Converting the sub-sample waveform in FIGURE 5A to FIGURE 6A is the function of mixer 14. This function of alternating the sign between even and odd time slots is achieved by effectively multiplying the signal by a sinusoidal carrier frequency waveform which is the carrier modulation function. The implementation consists of mixers 14-1 and 14-2 used for the positive DMS and mixers 14-3 and 14-4 for the negative DMS. Mixer 14-1 sorts out the odd time slot positive DMS waveform and mixer 14-2 sorts out the even time slot positive DMS waveform. This configuration repeats for the negative DMS waveform, by mixers 14-3 and 14-4. The "OR" gates 14-5 and 14-6 combine the odd and even slot waveforms from the "AND" gates 14-1 and 14-3 and 14-2 and 14-4 respectively. The odd time slot output of "OR" gate 14-5 is connected to the positive load driver while the even time slot output of "OR" gate 14-6 is connected to the negative load driver.

FIGURE 6B shows the normalized frequency response of the sub-sample waveform from 1 to 15 levels and normalized to the highest level, i.e. 15. One can see the peak power is a frequency of 15 times the sampling frequency. The out of band signal is attenuated by 15 dB over the frequency range of 13 to 14 times the sampling frequency.

An example of designing a mobile CDMA transmitter 900 MHz system is shown in Chart 1 below. The carrier frequency range is 824 to 836.5 MHz. The number of channels in the frequency is 10. Channel bandwidth is 1.25 MHz.

The center carrier frequencies are shown in Chart 1.

| Channel # | Frequency |
|---|---|
| 1 | 824.625 |
| 2 | 825.875 |
| 3 | 827.125 |
| 4 | 828.375 |
| 5 | 829.625 |
| 6 | 830.875 |
| 7 | 832.125 |
| 8 | 833.375 |
| 9 | 834.625 |
| 10 | 835.875 |

From the frequency range, the minimum sampling rate is half the range, e.g. 6.25 MHz. The number of sub-intervals is 824.625/6.25 ~ 256. The sampling frequency is 6.44238 MHz and carrier frequency is 644238x 128 =824.62446 MHz. The signal to noise ratio is equivalent to 9 bits (128 level magnitude + one sign bit + 1 bit for over sampling).

Chart 2 shows the sampling frequencies.

| Channel # | Sampling | Frequencies Carrier | Carrier frequency error | Unit |
|---|---|---|---|---|
| 1 | 6.44238 | 824.62464 | 0.00036 | MHz |
| 2 | 6.45215 | 825.8752 | -0.0002 | MHz |
| 3 | 6.46191 | 827.12448 | 0.00052 | MHz |
| 4 | 6.47168 | 828.37504 | 0.00004 | MHz |
| 5 | 6.48145 | 829.6256 | -0.0006 | MHz |
| 6 | 6.49121 | 830.87488 | 0.00012 | MHz |
| 7 | 6.50098 | 832.12544 | -0.00044 | MHz |
| 8 | 6.51074 | 833.37472 | 0.00028 | MHz |
| 9 | 6.52051 | 834.62528 | -0.00028 | MHz |
| 10 | 6.53027 | 835.87456 | 0.00044 | MHz |

FIGURE 4 is an illustration of on embodiment of sub-samples in a sampling interval. Each sampling interval is divided into M equally spaced sub-sample intervals and each sub-sample interval would transmit one sub-sample value. The preference is to have two level sub-sample value, e.g. 1 or 0. However, the modulation scheme can support multi-level sub-sample values. The sum of all sub-sample values equals the sample value. By using this approach the dynamical range of circuitries that are necessary to support the samples is reduced substantially, e.g. by N where N is the number of sub sample intervals in one sample period. Note that the presentation of sample value has two dimension; namely, the magnitude of the sub-sample values and the density of the sub-sample values. This then allows carrier modulated signal generation to be performed by digital circuits.

Note that the input signal can be an analog signal on input 131 (FIGURE 3)or it could be a digital signal or a quantized digital signal on input 132. In addition, the signal can be serial (as shown at input 132) or parallel (as shown at terminals 133-1 to 133-N) in format. The carrier frequency could be built into the device or it can be obtained via an input, such as input 130. The sign bit would be provided via terminal 134.

Although the present invention and its advantages have been described in detail, it should be understood that various changes, substitutions and alterations can be made herein without departing from the spirit and scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A power amplifier comprising:
means for accepting a baseband signal to be amplified; and
means for digitally up-converting a center frequency of said accepted baseband signal to a modulated carrier signal, said up-converting comprising using a sampling frequency to create samples of said accepted input signal into sub-samples within a sample interval.

2. The power amplifier of claim 1 further comprising:
an analog gate; and
wherein output power of said modulated carrier signal is determined, at least in part, by the number of half cycles of said carrier signal allowed to pass through said analog gate.

3. The power amplifier of claim 2 further comprising:
an output stage comprising a load modulator driven by transformers having oppositely phased windings.

4. The power amplifier of claim 3 wherein said sampling frequency determines power output.

5. The power amplifier of claim 3 further comprising:
a mixer for transforming said baseband signal to a carrier frequency half of said sub-sample clock frequency.

6. A method of modulating a carrier signal, said method comprising:
generating from a baseband input signal a digitally quantized signal having M bits plus one sign bit in each parallel signal sample,
weighting said M bits for each sample in increasing significant bit order with a weight coding using an orthogonal coding pattern;
dividing each digitally quantized signal portion into a plurality of equally spaced sub-samples, where the sum of said sub-samples equal the value of a respective sample portion;
combining said weighted bits into a digital modulation signal; and
modulating sub-samples of said baseband input signal with said digital modulation signal and with said sign bit to arrive at an output modulated signal.

7. The method of claim 6 wherein said alternating sign bit alternates from plus to minus with each successive parallel sample.

8. The method of claim 7 wherein said carrier signal has a frequency of at least 500 MHz.

9. The method of claim 8 further comprising:
transforming said baseband signal to a carrier frequency half of said sub-sample clock frequency.

10. A modulation circuit comprising:
circuitry for converting an input signal into a digitally quantized signal having M bits plus one sign bit in each sample,
circuitry for establishing an orthogonal coding pattern with respect to said input signal, said pattern having a plurality of equally spaced sub-samples for each signal ample in a sample interval;
gate circuitry for weighting each said M parallel bits s in increasing significant bit order;
gating said orthogonal coded signals into a digital modulation signal (DMS) using said gate circuitry in combination with said sign bits for each said sample; and
load circuitry for combining the plus and minus sign portions of said DMS signal into a single output signal.

11. The modulator of claim 10 wherein output power of said output signal is determined, at least in part, by the number of half cycles of said input signal allowed to pass through said gate.

12. The modulator of claim 11 wherein said amplifier is a Class D amplifier and wherein said carrier is a single frequency.

13. A transmitter comprising:
circuitry for accepting a baseband signal;
circuitry for digitally up-converting a center frequency of said accepted baseband signal to a modulated carrier signal, said up-converting comprising using a sampling frequency to create samples of said accepted baseband signal into sub-samples within a sample interval;
at least one analog gate; and
wherein output power of said of said modulated carrier signal is determined, at least in part, by the number of half cycles of said carrier signal allowed to pass through said analog gate.

14. The transmitter of claim 13 further comprising:
an output stage comprising a load modulator driven by transformers having oppositely phased windings.

15. The transmitter of claim 14 wherein said sampling frequency determines power output.

16. The transmitter of claim 15 further comprising:
a mixer for transforming said baseband signal to a carrier frequency half of said sub-sample clock frequency.

17. The transmitter of claim 13 wherein said transmitter is a CDMA transmitter.

18. The transmitter of claim 17 having a carrier frequency range of 824 to 836.5 MHz; with a channel bandwidth of 1.25MHz and having 10 channels with a sampling frequency of 6.44238MHz.
